# EUROPEAN PATENT APPLICATION

(11) **EP 1 744 588 A1**
(43) Date of publication of application: **17.01.2007**
(21) Application number: 05728868.0
(22) Date of filing: 04.04.2005
(51) Int. Cl.: H04R 3/00, H03G 3/00, H03G 3/02

(54) **SOUND VOLUME CONTROL CIRCUIT, SEMICONDUCTOR INTEGRATED CIRCUIT, AND SOUND SOURCE DEVICE**

(30) Priority: 06.04.2004 JP 2004111959
(71) Applicant: ROHM CO., LTD., Kyoto-shi, Kyoto 615-8585 (JP)
(72) Inventor: KURIHARA, Naoki, c/o Rohm Co., Ltd., Kyoto-shi Kyoto 6158585 (JP)
(74) Representative: Cross, Rupert Edward Blount
(86) International application number: PCT/JP2005/006620
(87) International publication number: WO 2005/099304

(57) **Abstract**

In a sound volume circuit (100), an attenuation coefficient setting register (28) holds an attenuation coefficient "b". When a stop instruction STOP becomes active, an output signal "a" from a first multiplexer (14), i.e., a processing object signal "in" is multiplied by the attenuation coefficient "b" by a multiplier (16), and the output signal "c" is outputted via a second multiplexer (18), a first flip-flop (20), and a third multiplexer (22). A multiplication master counter (38) holds the number of times the processing object signal "in" acquired by one sampling is multiplied by "b". The multiplication master counter (38) counts up by using a timer (36). A multiplication temporary counter (32) loads the output signal from the multiplication master counter (38) at the assert of an acquisition timing signal "L". The process from the first multiplexer (14) to the first flip-flop (20) is repeated by the number of times of the multiplication temporary counter (32).

## Description

This invention relates to a sound volume controlling technology, and it particularly relates to a sound volume circuit, a semiconductor integrated circuit and a sound source device in which the sound volume of an input signal which is a signal to be processed is reduced and then outputted.

In a wireless mobile equipment where the portable telephones are the main device, the sound quality of calls and so forth affects the appeal power of a product. In such equipment, the audio is outputted to a speaker, earphone, headphone and the like from the three systems of circuits, that is, a sound source, a CODEC and a DTMF (Dual Tone Multi Frequency). The audio quality should be evaluated for each of these systems. However, we experience on a daily basis that the abrupt change in sound volume impairs the subjective quality. In Japanese Patent Laid Open Publication H08-139539, the fact that the gain of an amplifier abruptly changes by the on-off of an analog switch accounts for a cause of reduction in sound quality. And an automatic sound-volume adjusting apparatus provided with a gain adjustment means to avoid this phenomenon is disclosed there.

In Japanese Patent Laid Open Publication H08-139539, a structure is such that the gain is gradually raised when the level of audio signal received becomes a standard value or less. Thus, the sound volume can be adjusted without sense of discomfort in terms of the auditory sensation. Nevertheless, the similar problem to be solved arises not only when such steady sound volume is adjusted but also when the audio is down completely. That is, when the sound is interrupted simultaneously with the switching-off, there are cases where great discomfort results and remains in terms of the auditory sensation. Related art list
JPA Laid Open H08-139539

The present invention has been made in view of these circumstances and a general purpose thereof is to provide a sound-volume controlling technology by which to obtain an auditorily natural effect when audio is switched off.

A sound volume control circuit according to the present invention includes: a volume circuit which lowers a sound volume of a signal to be processed and generates an output signal after an output stop instruction is issued; a setting circuit which sets a reduction amount in one reduction processing when the sound volume of the signal to be processed is reduced by the volume circuit; and a control circuit which increases the number of reduction processings while the sound volume of the signal to be processed is being lowered by the volume circuit. According to this structure, the number of reduction processings increases gradually, so that the reduced amount of sound volume increases gradually and an auditorily natural mute effect is obtained.

The control circuit may include a timer, and in that case the number of reduction processings may be increased at intervals of predetermined time timed by the timer. It may further include an off circuit that forcibly zeros the sound volume when a predetermined end time comes by using the timer.

The volume circuit may retrieve the signal to be processed at a predetermined acquisition sampling frequency and perform the reduction processing by the number of times increased by the control circuit in a period of time shorter than a cycle of the acquisition sampling frequency. According to this structure, the signal to be processed is retrieved at each sampling timing and the reduction processing is performed on the signal to be processed. Hence, there will be no jumpiness caused and the sound volume can be lowered smoothly.

It is to be noted that any arbitrary combination of the aforementioned constituent elements and the expression of the present invention changed among a method, an apparatus, a system, a recording medium, a computer program and so forth are also effective as the embodiments of the present invention.
FIG. 1 illustrates a structure of a sound source device according to an embodiment;
FIG. 2 illustrates a structure of a sound volume control circuit according to an embodiment; and
FIG. 3 is a flowchart showing an operation of a sound volume control circuit.

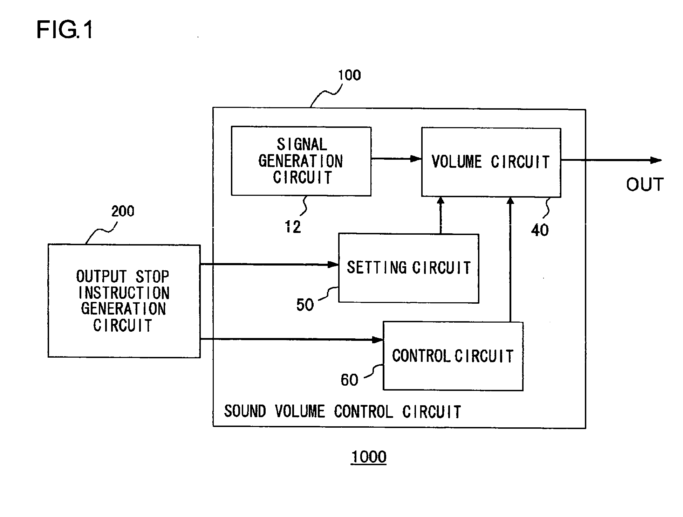

FIG. 1 illustrates a general structure of a sound source device 1000, including a sound volume control circuit 100, according to an embodiment. This sound source device 1000 includes a sound volume control circuit 100 which controls the sound volume of audio signals and an output stop instruction generation circuit 200 which generates an instruction to stop the output of audio. The sound volume control circuit 100 includes a signal generation circuit 12 which outputs audio signals, a volume circuit 40 which reduces the sound volume of a signal to be processed so as to generate an output signal, after an output stop instruction has been issued, a setting circuit 50 which sets a reduction amount in one reduction processing when the sound volume of a signal to be processed is reduced by the volume circuit 40, and a control circuit 60 which increases the number of reduction processings during a period of time in which the sound volume of a signal to be processing is reduced by the volume circuit 40.

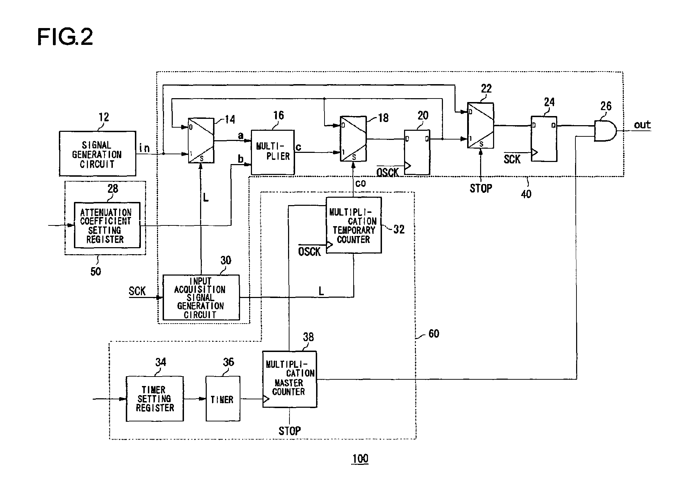

FIG. 2 illustrates a structure of a sound volume control circuit 100 according to an embodiment. The volume circuit 40 principally includes a multiplier 16, and a first multiplexer 14, a second multiplexer 18, a first flip-flop 20 and an input acquisition signal generation circuit 30 which are placed in the vicinity of the multiplier 16. The setting circuit 50 principally includes an attenuation coefficient setting register 28. The control circuit 60 principally includes a multiplication master counter 38 and a multiplication temporary counter 32. However, each of the circuits may have its peripheral circuitry and, for example, the control circuit 60 may includes a timer setting register 34 and a timer 36.

The signal generation circuit 12 is an arbitrary circuit that outputs audio signals. The signal generation circuit 12 may, for example, be a sound source circuit, a CODEC, a DTMF circuit or the like. An output signal of the signal generation circuit 12 is a signal to be processed (in). The first multiplexer 14 selects a signal to be inputted to either a first input terminal 0 or a second input terminal 1 in accordance with an acquisition timing signal L inputted to a selection signal input terminal s and then outputs it. An output signal of the first flip-flop 20 described later is fed to the first input terminal 0, whereas the signal to be processed (in) is fed to the second input terminal 1.

The multiplier 16 multiplies the signal to be processed (in), which is an output signal **a** of the first multiplexer 14, by an output signal **b** of the attenuation coefficient setting register 28, and then outputs a signal **c** representing a multiplication result (hereinafter, these three values may sometimes be abbreviated as a, b and c, respectively). The second multiplexer 18 selects a signal to be inputted to either a first input terminal 0 or a second input terminal 1 in accordance with a count-over signal co inputted to a selection signal input terminal s and then outputs it. The output signal of the first flip-flop 20 is fed to the first input terminal 0, whereas c is fed to the second input terminal 1. The output signal of the second multiplexer 18 is fed to an input terminal D of the first flip-flop 20, whereas an over-sampling clock OSCK which is the fastest in this system is fed to a clock input terminal of the first flip-flop 20.

A third multiplexer 22 selects a signal to be inputted to either a first input terminal 0 or a second input terminal 1 in accordance with a stop instruction STOP inputted to a selection signal input terminal s and then outputs it. The stop instruction STOP is an instruction STOP by which to stop the sound to be inputted. A signal to be processed (in) is fed to the first input terminal 0, whereas an output signal of the first flip-flop 20 is fed to the second input terminal 1. The output signal of the third multiplexer 22 is inputted to an input terminal D of a second flip-flop 24. When the stop instruction STOP inputted to the selection signal input terminal s becomes active, the third multiplexer 22 outputs an input signal of the second input terminal 1. Hence, an output of the signal generation circuit 12, namely the signal to be processed (in), is directly outputted to the second flip-flop 24 during a period of time in which the stop instruction STOP is not inputted to the third multiplexer 22. The stop instruction STOP is a level signal. A sampling clock SCK of audio processing system is fed to a clock input terminal of the second flip-flop 24, whereas an output signal of the second flip-flop 24 is fed to either one of input terminals of a mask circuit 26 which is an AND gate. Although it is assumed that the stop instruction STOP is generated due to an operation where a user switches off the power of a device equipped with the sound volume control circuit 100, switches off the sound and so forth, its cause of the occurrence and the generation circuit therefor are not considered here.

When the attenuation coefficient setting register 28 reduces the sound volume, it holds an amount to be reduced by one reduction processing (hereinafter referred to as "attenuation coefficient") **b**. The attenuation coefficient setting register 28 can be set from software. For instance, when 0.8 is set as the attenuation coefficient **b**, this value is multiplied by the signal to be processed (in), which is outputted from the first multiplexer 14, in the multiplexer 16 and then the sound volume becomes 0.8 times as a result of one reduction processing. The attenuation coefficient **b** of the attenuation coefficient setting register 28 will not change until it is reset from software.

The input acquisition signal generation circuit 30 generates an acquisition timing signal L by which to fetch in the signal to be processed (in). As will be described later, this acquisition timing signal L is synchronous with a clock edge which has a phase slightly delayed from that of a sampling clock SCK. This acquisition timing signal L is fed to the first multiplexer 14 and the multiplication temporary counter 32. When the acquisition timing signal L is asserted, the first multiplexer 14 selects the input signal of the second input terminal 1 and then the signal to be processed (in) is inputted to the multiplier 16. At timings other than this, the first multiplexer 14 selects the input signal of the first input terminal 0, and then the signal to be processed (in) which has already been fetched in is inputted repeatedly to the multiplier 16. Such an operation realizes a plurality of reduction processings by a plurality of multiplications.

When the acquisition timing signal L is asserted, the multiplication temporary counter 32 loads the output signal of multiplication master counter 38. The multiplication temporary counter 32 is a down-counter; every time a rising edge of over-sampling clock OSCK occurs, the multiplication temporary counter 32 decrements the internal value; and the multiplication temporary counter 32 asserts the count-over signal co active from after the value has become zero until a count operation is started. This count-over signal co is inputted to the selection signal input terminal s of the second multiplexer 18. During a period of time in which the count-over signal co is active, the second multiplexer 18 selects the signal inputted to the first input terminal 0. As a result thereof, the signal is looped through the first flip-flop 20 and the second multiplexer 18, and the reduction processing for sound volume is skipped, so that the sound volume becomes constant.

The multiplication master counter 38 sets the number of reduction processings performed to the acquired signal to be processed (in) repeated. The multiplication master counter 38 is an up-counter; and every time a predetermined period of time has elapsed, the internal value is incremented. The predetermined period of time is set to the timer setting register 34 from software, and the timer 36 is controlled by output signals of the timer setting register 34.

The stop instruction STOP is also inputted to the multiplication master counter 38. During a period of time when this stop instruction STOP is inactive, namely during a normal operation, the multiplication master counter 38 is in a fixed state. Then, in the present embodiment it is assumed that the internal value of the multiplication master counter 38 is fixed to "1". When the stop instruction STOP becomes active, the multiplication master counter 38 counts up every time a predetermined period of time timed by the timer 36 has elapsed. Then the respective values of the multiplication master counter 38 are loaded into the multiplication temporary counter 32 through the acquisition timing signal L. It is assumed herein that the cycle of an output signal of the timer 36 is sufficiently long as compared to the cycle of the acquisition timing signal L. Accordingly, if the timing at which the acquisition timing signal L is asserted is used as a reference, the values loaded into the multiplication temporary counter 32 will increase as in a case where a predetermined period of time is "1" followed by a predetermined period of time of "2" in an example of "1" "1" ... "1" "2" "2" ... "2" ... .

On the other hand, the multiplication temporary counter 32 itself does the counting down by the over-sampling clock OSCK. Therefore, if the over-sampling clock OSCK is used as a reference, the count-over signal co of the multiplication temporary counter 32 will be

1→0→0→0→...→0

And when "1" is loaded again by the acquisition timing signal L, the change of

1→0→0→0→...→0

is repeated again. In the meantime, when the timer 36 times elapse of a predetermined time, the value of the multiplication master counter 38 is incremented and "2" is loaded into the multiplication temporary counter 32. As a result, the count-over signal co of the multiplication temporary counter 32 repeats

2→1→0→0→...→0

While decreasing in the order of "2", "1", and "0", the signal to be processed (in) passes the multiplier 16 three times, as will be discussed later, and the sound volume becomes b³ times the original.

When the internal value becomes a predetermined value of "6", for example, it is regarded that the sound volume has been sufficiently lowered and, from then onward, the multiplication master counter 38 outputs a mask signal to zero the sound volume, at low level. This signal is inputted to the mask circuit 26. The mask circuit 26 is an off circuit that forcibly zeros the sound volume.

An outline of an operation by the above structure will be described. Assume that, prior to a processing, necessary values have been set in the attenuation coefficient setting register 28 and the timer setting register 34. During a normal operation in which the stop instruction STOP is inactive, a signal to be processed (in) from the signal generation circuit 12 is selected in the third multiplexer 22, and this is sampled by a sampling clock SCK, which is a basic clock in an audio processing system, in the second flip-flop 24, and is outputted via the mask circuit 26 as a output signal **out.** During this time, too, the signal to be processed (in) is inputted from the first multiplexer 14 to the multiplier 16 every time the acquisition timing signal L is asserted, and the multiplication processing continues to progress.

On the other hand, when the stop instruction STOP becomes active, the third multiplexer 22 first switches and the output signal of the first flip-flop 20 is transmitted to the second flip-flop 24. The retrieved signal to be processed (in) is multiplied by an attenuation coefficient **b** in the multiplier 16, and the multiplication result c(=ab) is outputted from the second multiplexer 18 to the first flip-flop 20. Since the initial value of the multiplication temporary counter 32 is the same as the initial value "1" of the multiplication master counter 38, the output signal of the multiplier 16 is outputted only once from the second multiplexer 18 to the first flip-flop 20. Thereafter, a loop through the second multiplexers 18 and the first flip-flops 20 is formed, so that the output signal is remained and fixed at c(=ab). Thus, no matter how many more times the edge of over-sampling OSCK arrives thereafter, the sound volume by a factor of b is outputted as the output signal.

After this output, the next signal to be processed (in) is retrieved to the multiplier 16 by the acquisition timing signal L via the first multiplexer 14. Since the acquisition timing signal L has the same frequency as the sampling clock SCK, the signals to be processed (in) are taken in without jumpiness. At the same time as this, "1" is again loaded to the multiplication temporary counter 32 from the multiplication master counter 38, so that c(=ab) is again obtained as the output signal.

When the similar operation continues and the timer 36 times the predetermined time, "2" is loaded to the multiplication temporary counter 32 from the multiplication master counter 38. As a result, the second multiplexer 18 selects the path of the second input terminal 1 twice. Thus, after the signal to be processed (in) passes through the first multiplexer 14, the multiplier 16, the second multiplexer 18 and the first flip-flop 20 in this order, it again passes through the first multiplexer 14, the multiplier 16, the second multiplexer 18 and the first flip-flop 20. From then on, the second multiplexer 18 selects the first input terminal 0, and a loop through the second multiplexer 18 and the first flip-flop 20 is formed. Hence, the output signal is fixed at the multiplication result of c=ab². This operation continues until the timer 36 next measures the predetermined time. Thus, the signal to be processed (in) becomes an output signal having a sound volume by the factor of b² in the timing of each sampling clock SCK so as to be outputted.

When the output signals are arranged in the timings of sampling clock SCK based on the above operation, the following sequence results.

ab→ab→...→ab→ab²→ab²...→ab²→ab³→ab³→...→ab³→...

Thereafter, when the value of the multiplication master counter 38 becomes "6", for example, a mask signal is outputted to the mask circuit 26 from the multiplication master counter 38 and therefore the output signal out is completely cut off. As can be seen from the above general description on an operation, since it is necessary that the count-down result is zero in the multiplication temporary counter 32 during from the input of a certain acquisition timing signal L until the input of the next acquisition timing signal L, the over-sampling clock OSCK should be sufficiently faster than the sampling clock SCK. Consideration is given such that the basic clocks for these clocks and the timer 36 have a predetermined synchronous relation and phase relation when a strict design is to be made and also the clock racing and hazard will not occur in the timing of circuit switching or signal latching.

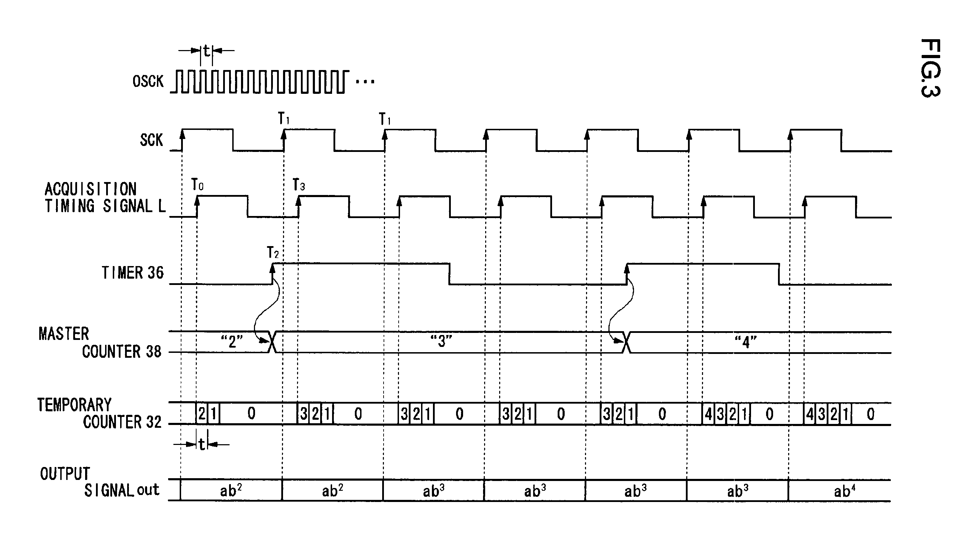

FIG. 3 is a timing chart showing the above operation. Here, one cycle of the over-sampling clock OSCK is denoted by t. The acquisition timing signal L is a signal slightly delayed from the over-sampling clock. In the same figure, the stop instruction STOP is already active, the timer 36 times the predetermined time once, and the value of the multiplication master counter 38 is "2" already at the time of start.

At time T0 in the same figure, when the acquisition timing signal L rises, "2" which is the value of multiplication master counter 38 at that time is loaded into the multiplication temporary counter 32. The value of the multiplication temporary counter 32 is decremented by the over-sampling clock OSCK and becomes "2"→"1"→"0" and the signal to be processed (in) attenuates to c=ab². The periods of time in which the multiplication temporary counter 32 has each value other than "0" are equal to t, respectively. After the output signal of the multiplication temporary counter 32 becomes "0" and then the sufficient hold time is secured, the signal of c=ab² is sampled in the next sampling time T1 and is then outputted from the second flip-flop 24.

On the other hand, the timer 36 has completed timing the predetermined time at time T2, and the output signal has changed. With this rising edge, the internal value of the multiplication master counter 38 increments to "3". This value is retrieved to the multiplication temporary counter 32 at the time T3 of inputting the next acquisition timing signal L, so that the value of the multiplication temporary counter 32 changes as "3"→"2"→"1"→"0" and the signal to be processed (in) attenuates to c=ab³. Here, too, after the output signal of the multiplication temporary counter 32 has become "0" and secured the sufficient hold time, the signal of c=ab³ is sampled at the next sampling timing T1 and is then outputted from the second flip-flop 24. Subsequently, the output signal is gradually lowered in the similar manner, and finally it is completely cut off by the mask circuit 26 after a certain period of time. As described above, according to the present embodiment the sound volume can be gradually lowered after the instruction to stop the output of sound has been issued, thereby giving rise to an auditorily natural effect.

The present invention has been described based on the embodiments. These embodiments are merely exemplary, and it is understood by those skilled in the art that various modifications to the combination of each component and process thereof are possible and such modifications are also within the scope of the present invention. Such modification will be cited as follow.

In the present embodiments, the sound volume is lowered logarithmically but how to lower it is not limited thereto. For instance, the values of attenuation coefficients set in the attenuation coefficient setting register 28 may also be varied. For example, a number X which is less than 1, such as "0.7", and a number Y which is greater than or equal to 1, such as "1.1" (where X+Y<2) are set alternately in the attenuation setting register 28. Thereby, the sound volume can be gradually lowered while the undulation is being added to the sound, thus realizing a special effect. As other examples than this, various effects can be achieved by controlling the attenuation coefficients to be set.

In the present embodiments, a case is considered where the sound volume control circuit 100 is incorporated into mobile equipment, but the case is not limited thereto. Any equipment will suffice as long as it has a mechanism of outputting audio.

## Claims

1. A sound volume control circuit (100), including:
a volume circuit (40) which lowers a sound volume of a signal to be processed and generates an output signal after an output stop instruction is issued;
a setting circuit (50) which sets a reduction amount in one reduction processing when the sound volume of the signal to be processed is reduced by said volume circuit (40); and
a control circuit (60) which increases the number of reduction processings while the sound volume of the signal to be processed is reduced by said volume circuit (40).

2. A sound volume control circuit (100) according to Claim 1, wherein said control circuit (60) includes a timer (36), and the number of reduction processings is increased at intervals of predetermined time timed by the timer (36).

3. A sound volume control circuit (100) according to Claim 2, wherein said control circuit (60) includes a timer setting register (34) which controls the timer (36) based on the time interval at which the set number of reduction processings is increased.

4. A sound volume control circuit (100) according to Claim 1 or Claim 2, wherein said volume circuit (40) retrieves the signal to be processed at a predetermined acquisition sampling frequency and performs the reduction processing by the number of times increased by said control circuit (60) in a period of time shorter than a cycle of the acquisition sampling frequency so as to generate the output signal.

5. A sound volume control circuit (100) according to Claim 1 or Claim 2, wherein said volume circuit (40) includes an output circuit (24, 26) which retrieves the signal to be processed which has undergone the reduction processing, at an output sampling frequency and outputs it as the output signal.

6. A sound volume control circuit (100) according to Claim 4, wherein said volume circuit (40) includes a multiplier (16) which multiplies an input signal by a coefficient according to the reduction amount set by said setting circuit (50), and said volume circuit (40) performs the reduction processing by inputting repeatedly the signal to be processed to the multiplier (16) as many times as the number of times increased by said control circuit (60).

7. A sound volume control circuit (100) according to Claim 2, wherein said volume circuit (40) includes a mask circuit (26) which outputs the signal to be processed, in a manner that the sound volume thereof is zero, when elapsed time, timed by the timer (36), from a start of the reduction processing exceeds a predetermined period of time.

8. A semiconductor integrated circuit (100) in which the sound volume control circuit (100) according to Claim 1 is integrally integrated.

9. A sound source device (100), comprising:
an audio signal generation circuit (12) which outputs an audio signal that is a signal to be processed;
an output stop instruction generation circuit (200) which generates a signal indicative of an output stop instruction for the audio signal; and
a sound volume control circuit (100) according to Claim 1,
wherein by the signal indicative of an output stop instruction, the sound volume of the audio signal, which is a signal to be processed, outputted by said audio signal generation circuit (12) is lowered by said sound volume control circuit (100) so as to be outputted.
